(19) 

**Europäisches Patentamt**

**European Patent Office**

**Office européen des brevets**

(11) **EP 4 350 366 B1**

(12) **FASCICULE DE BREVET EUROPEEN**

(45) Date de publication et mention
de la délivrance du brevet:
**18.12.2024 Bulletin 2024/51**

(21) Numéro de dépôt: **23200223.8**

(22) Date de dépôt: **27.09.2023**

(51) Classification Internationale des Brevets (IPC):
**G01R 31/08** (2020.01)     **G01R 31/11** (2006.01)

(52) Classification Coopérative des Brevets (CPC):
**G01R 31/083; G01R 31/085; G01R 31/088;
G01R 31/11**

(54) **MÉTHODE D'ÉVALUATION D'UNE LIGNE DE TRANSMISSION PAR ANALYSE AUTOMATIQUE
D'UN RÉFLECTOGRAMME**

VERFAHREN ZUR BEURTEILUNG EINER ÜBERTRAGUNGSLEITUNG DURCH AUTOMATISCHE
ANALYSE EINES REFLEKTOGRAMMS

METHOD OF EVALUATING A TRANSMISSION LINE BY AUTOMATIC REFLECTOGRAM ANALYSIS

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **03.10.2022 FR 2210081**

(43) Date de publication de la demande:
**10.04.2024 Bulletin 2024/15**

(73) Titulaire: **Commissariat à l'Energie Atomique et
aux Energies
Alternatives
75015 Paris (FR)**

(72) Inventeurs:
• **RAVOT, Nicolas
91191 GIF-SUR-YVETTE CEDEX (FR)**

• **NALINE, Baudouin
91191 GIF-SUR-YVETTE CEDEX (FR)**
• **BLANCHART, Pierre
91191 GIF-SUR-YVETTE CEDEX (FR)**
• **GREGIS, Nicolas
91191 GIF-SUR-YVETTE CEDEX (FR)**

(74) Mandataire: **Atout PI Laplace
Immeuble Up On
25 Boulevard Romain Rolland
CS 40072
75685 Paris Cedex 14 (FR)**

(56) Documents cités:
**US-A1- 2014 316 726     US-A1- 2018 059 164
US-A1- 2021 278 452**

**Description**

L'invention concerne le domaine des systèmes et procédés de diagnostic de l'état de santé d'un câble ou plus généralement d'une ligne de transmission. Elle entre dans le champ des méthodes de diagnostic par réflectométrie qui visent à détecter et localiser des défauts électriques sur un câble ou sur un réseau de câbles.

L'invention porte plus précisément sur une méthode d'évaluation des discontinuités d'impédance sur une ligne de transmission par analyse automatisée d'un réflectogramme.

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées, en toron de câble ou autre. L'invention peut également s'appliquer à des câbles mécaniques, par exemple des câbles de soutien d'infrastructures telles un ascenseur ou un pont.

Les lignes de transmission peuvent être exposées à des conditions contraignantes internes et externes qui sont à la fois des perturbations naturelles et artificielles telles que des fluctuations de température, l'humidité, la pression, etc., entraînant ainsi l'apparition d'anomalies souvent appelées défauts. Ces défauts peuvent être localisés sur un point dans le cas des circuits ouverts ou des courts-circuits (défauts francs). Les défauts peuvent aussi résulter de dégradations superficielles du câble, on parle alors de défauts non francs.

Au cours des dernières décennies, des efforts considérables ont été investis dans la recherche et l'industrie pour étudier et développer des techniques capables de détecter la présence, la localisation et les caractéristiques de défauts de câblage susceptibles de mettre en péril les infrastructures dépendant de ces réseaux. Par conséquent, la surveillance des pannes et le dépannage des câbles sont devenus un problème important afin de garantir un fonctionnement sûr, des performances élevées et une rentabilité optimale.

Une des techniques connues permettant de détecter et localiser la présence d'un défaut est la technique dite de réflectométrie.

Selon un principe connu, les méthodes dites de réflectométrie sont utilisées pour détecter et/ou localiser des défauts électriques ou mécaniques qui engendrent des discontinuités ou des ruptures d'impédance dans un câble.

Ces méthodes utilisent un principe proche de celui du radar : un signal électrique, souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques qui peut donner à terme, une panne sévère par l'apparition d'un défaut franc.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'analyse est réalisée à l'aide d'un réflectogramme qui donne la réponse impulsionnelle du signal mesuré après sa rétropropagation dans le câble. Ce réflectogramme comporte différentes impulsions ou pics d'amplitude qui sont caractéristiques de discontinuités d'impédance dans le câble. L'analyse du réflectogramme afin de détecter et localiser d'éventuels défauts sur le câble est en général réalisée par le biais d'une interprétation subjective d'un expert du domaine qui est capable d'identifier la signature temporelle ou spectrale d'un défaut sur le réflectogramme.

Cependant, une personne non experte ne pourra pas forcément interpréter correctement un réflectogramme afin de fournir un diagnostic sur l'état de santé du câble. Il existe donc un besoin pour une méthode d'analyse et d'interprétation automatique d'un réflectogramme en vue de fournir un diagnostic.

Il existe des méthodes d'analyse automatique de signaux dans des domaines techniques éloignés comme le médical ou la reconnaissance de formes par imagerie.

Par exemple, la référence [1] concerne l'application des réseaux de neurones pour assurer la reconnaissance et la classification des ondes et des anomalies dans un signal électrocardiographique ECG. L'article [2] propose une méthode pour détecter automatiquement des pics sur des signaux bruités. Le document [3] a pour objectif de concevoir de nouvelles techniques de représentation de signaux et de faire en sorte que ces techniques augmentent la capacité d'un système SONAR passif à reconnaître et interpréter les signaux reçus par l'antenne placée en amont du système.

Cependant, aucun de ces documents ne concerne le domaine du diagnostic de l'état de santé de câbles et l'analyse automatique de réflectogrammes.

Le document US2018/059164 A1 divulgue une méthode d'évaluation d'une ligne de transmission par réflectométrie.

L'invention propose une nouvelle méthode d'analyse automatique de réflectogramme afin de classifier les discontinuités d'impédances détectées via leurs signatures temporelles ou spectrales en différentes catégories relatives à des défauts éventuels ou d'autres éléments physiques présents sur le câble.

L'invention se base notamment sur une méthode permettant de détecter l'influence mutuelle des impulsions voisines dans un réflectogramme afin de les séparer pour les isoler et caractériser précisément chaque impulsion.

L'invention a pour objet une méthode d'évaluation d'une ligne de transmission, par réflectométrie, comprenant les étapes de :

- Obtenir une mesure de la réponse impulsionnelle temporelle d'un signal de référence propagé dans la ligne à partir d'un point d'injection puis rétro-propagé en un point de mesure, la mesure temporelle, appelée réflectogramme, comprenant une pluralité de pics d'amplitude correspondant chacun à une discontinuité d'impédance,

- Rechercher un ensemble d'extrema locaux du réflectogramme,

- Déterminer une reconstruction totale du réflectogramme comme étant la somme d'impulsions ayant chacune la forme du signal de référence et la position et l'amplitude desdits extrema locaux,

- Pour chaque couple d'extrema locaux successifs d'indices j et j+1, comparer la reconstruction totale avec, respectivement, une première reconstruction partielle du réflectogramme pour les extrema locaux d'indices 0 à j et une seconde reconstruction partielle du réflectogramme pour les extrema locaux d'indices j+1 à N-1, N étant le nombre d'extrema locaux, pour déterminer si les impulsions d'indices j et j+1 du réflectogramme influent mutuellement l'une sur l'autre ou non,

- Pour un groupe d'impulsions du réflectogramme influant mutuellement les unes sur les autres, déterminer une reconstruction optimisée du groupe d'impulsions à partir d'une reconstruction partielle des impulsions du groupe de sorte à modifier les abscisses des impulsions de la reconstruction partielle pour minimiser un critère d'erreur entre la reconstruction partielle optimisée et le réflectogramme mesuré,

- Comparer la différence entre la reconstruction partielle optimisée et le réflectogramme mesuré à un premier seuil d'erreur et si la différence est inférieure au premier seuil d'erreur, classifier la discontinuité d'impédance associée à chaque impulsion du groupe d'impulsions en fonction de sa position et de son amplitude parmi les classes suivantes : un défaut non franc, un court-circuit, un circuit ouvert, une charge adaptée à la charge de la ligne de transmission, une désadaptation d'impédance entre le port de mesure et la ligne de transmission.

Selon un aspect particulier de l'invention, la forme du signal de référence est une impulsion Gaussienne.

Selon un aspect particulier de l'invention, l'étape de déterminer si les impulsions d'indices j et j+1 du réflectogramme influent mutuellement l'une sur l'autre ou non comprend les sous étapes de :

- Comparer une première différence entre la première reconstruction partielle et la reconstruction totale à un second seuil d'erreur,

- Comparer une seconde différence entre la seconde reconstruction partielle et la reconstruction totale au second seuil d'erreur,

- Si au moins l'une des différences parmi la première différence ou la seconde différence est supérieure au second seuil d'erreur, en déduire que les impulsions d'indices j et j+1 du réflectogramme influent mutuellement l'une sur l'autre, sinon en déduire qu'elles sont indépendantes.

Dans un mode de réalisation particulier, la méthode selon l'invention comprend l'étape de :

- Pour les impulsions du réflectogramme identifiées comme indépendantes, comparer la différence entre le réflectogramme et la reconstruction totale, dans une fenêtre temporelle encadrant l'impulsion, à un troisième seuil d'erreur,

- Si la différence est inférieure au troisième seuil d'erreur, classifier (306) la désadaptation d'impédance correspondant à l'impulsion en fonction de sa position et de son amplitude parmi les classes suivantes : un court-circuit, un circuit ouvert, une charge adaptée à la charge de la ligne de transmission, une désadaptation d'impédance entre le port de mesure et la ligne de transmission.

Selon un aspect particulier de l'invention, la reconstruction optimisée est obtenue au moyen d'un algorithme à régions de confiance.

Dans un mode de réalisation particulier, la méthode selon l'invention comprend l'étape de si la différence entre la reconstruction partielle optimisée et le réflectogramme mesuré est inférieure au premier seuil d'erreur pour deux impulsions successives, déterminer si les deux impulsions sont d'amplitudes sensiblement identiques et de signes opposés et si oui, classifier la désadaptation d'impédance correspondant à ces deux impulsions comme résultant d'un défaut non franc, si non classifier la désadaptation d'impédance correspondant à chacune des deux impulsions en fonction de sa position et de son amplitude parmi les classes suivantes : un court-circuit, un circuit ouvert, une charge adaptée à la charge de la ligne de transmission, une désadaptation d'impédance entre le port de mesure et la ligne de transmission.

Dans un mode de réalisation particulier, la méthode selon l'invention comprend l'étape de en outre une étape d'extraction de chaque impulsion associée à un extremum du réflectogramme, dans un intervalle temporel de largeur choisie telle que la distance entre le sommet de l'impulsion et ladite largeur est égale à un pourcentage prédéterminé, par exemple au moins égal à 80%, de la hauteur totale de l'impulsion.

Selon un aspect particulier de l'invention, le réflectogramme mesuré est normalisé en amplitude entre -1 et 1.

Selon un aspect particulier de l'invention, avant la comparaison avec le premier seuil d'erreur ou le troisième seuil d'erreur, le réflectogramme et la reconstruction partielle optimisée ou totale sont normalisées par rapport à l'extremum du réflectogramme.

Dans un mode de réalisation particulier, la méthode selon l'invention comprend en outre une étape de détermination des positions des discontinuités d'impédance à partir des abscisses temporelles des extrema du réflectogramme et une étape d'affichage des positions et types des discontinuités d'impédance sur une interface homme machine.

L'invention a pour objet un programme d'ordinateur comportant des instructions pour l'exécution de la méthode selon l'invention, lorsque le programme est exécuté par un processeur.

L'invention a pour objet un support d'enregistrement lisible par un processeur sur lequel est enregistré un programme comportant des instructions pour l'exécution de la méthode selon l'invention, lorsque le programme est exécuté par un processeur.

D'autres caractéristiques et avantages de la présente invention apparaîtront mieux à la lecture de la description qui suit en relation aux dessins annexés suivants.

[Fig. 1a] représente un schéma d'un premier exemple d'un système de réflectométrie temporelle,

[Fig. 1b] représente un schéma d'un second exemple d'un système de réflectométrie temporelle,

[Fig. 2] représente un exemple de réflectogramme obtenu avec le système de réflectométrie des figures 1a ou 1b pour un câble simple,

[Fig. 3] représente un organigramme détaillant les étapes de mise en oeuvre d'une méthode d'analyse automatique d'un réflectogramme selon un mode de réalisation de l'invention,

[Fig. 4] représente un exemple de réflectogramme temporel,

[Fig. 5] représente une illustration d'une étape de recherche de zones d'analyse sur le réflectogramme de la figure 4,

[Fig. 6] représente une illustration de deux impulsions combinées sur le réflectogramme de la figure 4,

[Fig. 7] représente un exemple de reconstruction totale obtenue selon une étape de la méthode objet de l'invention et une comparaison au réflectogramme,

[Fig. 8] représente un logigramme illustrant une étape d'analyse de combinaison potentielle de deux pics successifs du réflectogramme,

[Fig. 9] représente un exemple de reconstruction partielle obtenue selon une étape de la méthode objet de l'invention et une comparaison au réflectogramme,

[Fig. 10] représente une illustration d'un exemple d'influence mutuelle de plusieurs pics successifs d'un réflectogramme.

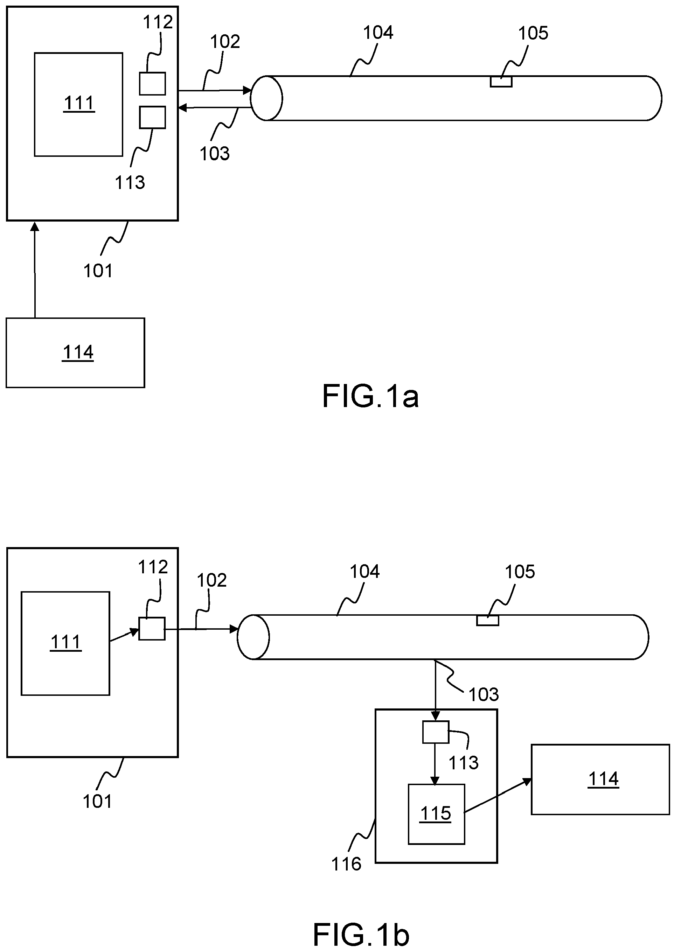

La figure 1a décrit un synoptique d'un exemple de système de réflectométrie temporelle. L'invention se positionne dans le contexte des méthodes de réflectométrie pour détecter, localiser ou caractériser les défauts impactant un câble ou plus généralement une ligne de transmission.

Sur la figure 1a, on a représenté un câble à tester 104 qui présente un défaut 105 à une distance quelconque d'une extrémité du câble. Sans sortir du cadre de l'invention, le câble 104 peut être remplacé par un réseau de câbles complexes interconnectés entre eux. Le câble simple 104 de la figure 1a est représenté dans un but purement illustratif afin d'expliciter le principe général d'une méthode de réflectométrie.

Un système de réflectométrie 101 selon l'invention comprend un composant électronique 111 de type circuit intégré, tel un circuit à logique programmable, par exemple de type FPGA, ou micro-contrôleur, adapté à exécuter deux fonctions. D'une part, le composant 111 permet de générer un signal de réflectométrie s(t) à injecter dans le câble 104 sous test. Ce signal généré numériquement est ensuite converti via un convertisseur numérique-analogique 112 puis injecté 102 à une extrémité du câble. Le signal s(t) se propage dans le câble et est réfléchi sur la singularité engendrée par le défaut 105. Le signal réfléchi est rétropropagé jusqu'au point d'injection puis capturé 103, converti numériquement via un convertisseur analogique-numérique 113, et transmis au composant 111. Le composant électronique 111 est en outre adapté à exécuter les étapes du procédé selon l'invention qui sera décrit ci-après pour, à partir du signal r(t) reçu, déterminer un réflectogramme ou plusieurs réflectogrammes.

Le ou les réflectogramme(s) peuvent être transmis à une unité de traitement 114, de type ordinateur, assistant numérique personnel ou autre pour afficher les résultats des mesures sur une interface homme-machine.

Le système 101 décrit à la figure 1a est un exemple de réalisation nullement limitatif. En particulier les deux fonctions exécutées par le composant 111 peuvent être séparées dans deux composants ou dispositifs distincts comme cela est illustré sur l'exemple de la figure 1b. Le point d'injection et le point de mesure du signal peuvent également être pris en des endroits quelconques du câble et non à son extrémité.

Sur la figure 1b, on a représenté un premier dispositif 101 dédié à la génération du signal de réflectométrie et à son injection dans le câble et un second dispositif 116 dédié à la mesure du signal en un point quelconque du câble puis au calcul du réflectogramme via un composant 115.

Le composant 115 peut être un composant électronique de type circuit intégré, tel un circuit à logique programmable, par exemple de type FPGA ou un microcontrôleur, par exemple un processeur de signal numérique, qui reçoit les mesures de signal et est configuré pour exécuter le procédé selon l'invention. Le composant 115 comporte au moins une mémoire pour sauvegarder les derniers échantillons de signal généré et injecté dans le câble et les derniers échantillons de signal mesuré.

Comme cela est connu dans le domaine des méthodes de diagnostic par réflectométrie temporelle, la position $d_{DF}$ d'un défaut 105 sur le câble 104, autrement dit sa distance au point d'injection du signal, peut être directement obtenue à partir de la mesure, sur le réflectogramme temporel calculé R(t), de la durée $t_{DF}$ entre le premier pic d'amplitude relevé sur le réflectogramme et le pic d'amplitude correspondant à la signature du défaut.

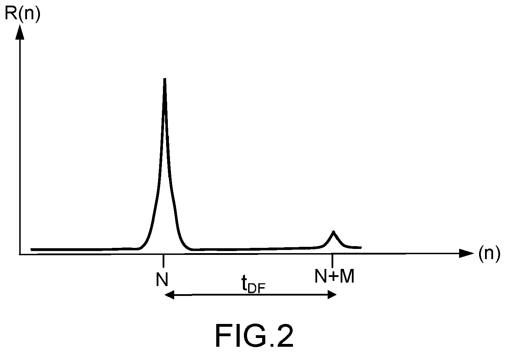

La figure 2 représente un exemple de réflectogramme R(n) obtenu à l'aide du système de la figure 1a ou 1b, sur lequel on observe un premier pic d'amplitude à une abscisse N et un second pic d'amplitude à une abscisse N+M. Le premier pic d'amplitude correspond au signal injecté au point d'injection dans le câble, tandis que le second pic correspond à la réflexion du signal sur une discontinuité d'impédance provoquée par un défaut.

Différentes méthodes connues sont envisageables pour déterminer la position $d_{DF}$ (distance du pic de fin de câble ou du défaut franc). Une première méthode consiste à appliquer la relation liant distance et temps : $d_{DF} = V_g \cdot t_{DF}/2$ où $V_g$ est la vitesse de propagation du signal dans le câble. Une autre méthode possible consiste à appliquer une relation de proportionnalité du type $d_{DF}/t_{DF} = L_c/t_0$ où $L_c$ est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble.

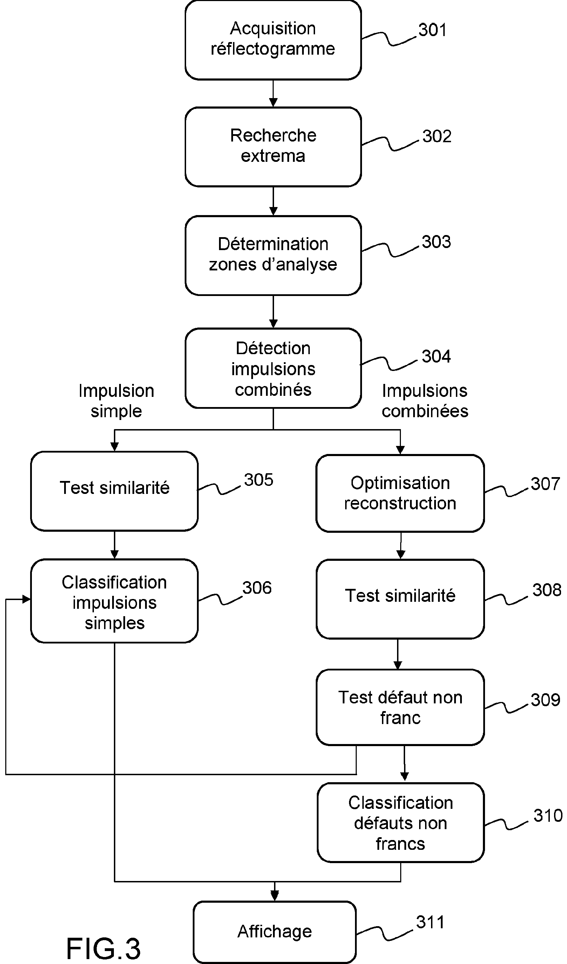

La figure 3 schématise, sur un organigramme, les étapes de mise en oeuvre d'une méthode d'analyse automatique d'un réflectogramme selon un mode de réalisation.

La méthode débute à l'étape 301 avec l'acquisition ou la réception d'un réflectogramme mesuré sur un câble à analyser au moyen du dispositif et de la méthode décrits ci-dessus. En plus du réflectogramme, la méthode peut recevoir en entrée la période d'échantillonnage du signal ainsi que la fréquence maximale du signal de référence utilisé pour exciter le câble.

Optionnellement, une étape de prétraitement est appliquée au préalable sur le réflectogramme mesuré afin par exemple d'augmenter le rapport signal à bruit par le biais d'un filtrage adapté.

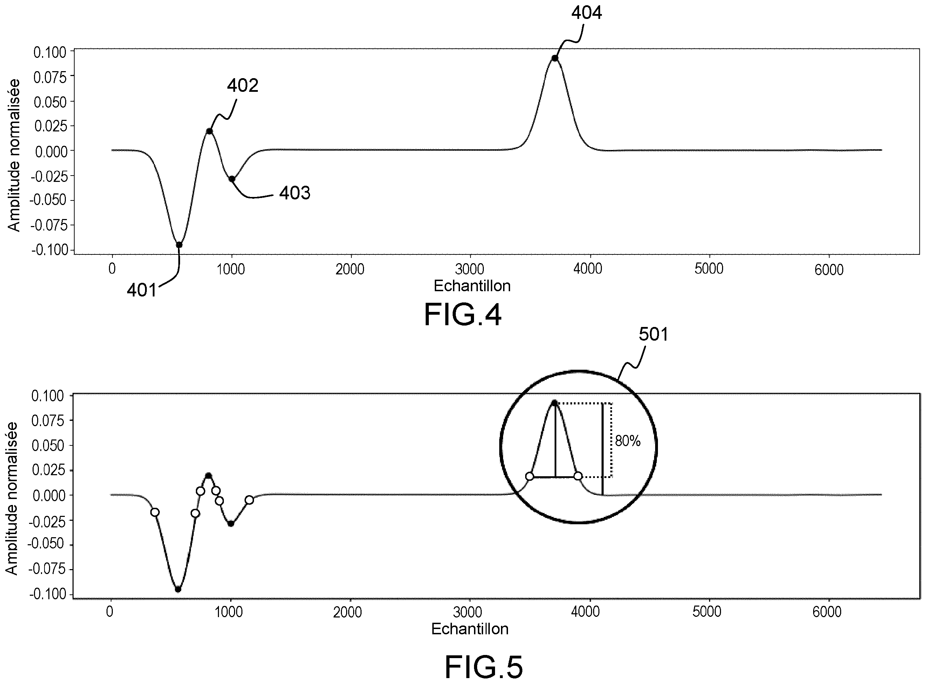

La figure 4 représente un exemple de réflectogramme mesuré pour un câble coaxial d'une longueur totale de 1 mètre et dont la terminaison correspond à une charge de 50 Ohms. Un défaut non franc de longueur 1 cm est situé à 10 cm du port d'injection du signal. Le signal d'excitation utilisé est un signal impulsionnel de forme Gaussienne de fréquence maximale 1 GHz.

L'exemple ci-dessus est donné à titre purement illustratif afin d'expliquer le fonctionnement de l'invention qui s'applique de façon identique à tout autre réflectogramme mesuré pour n'importe quel type de ligne de transmission.

A l'étape 302, une recherche d'extrema est réalisée sur le réflectogramme. Sur l'exemple de la figure 4, le réflectogramme comporte quatre extrema 401, 402, 403, 404.

L'étape 302 permet de repérer les zones du réflectogramme dans lesquelles il existe une probabilité élevée de détecter une signature temporelle correspondant à une discontinuité d'impédance sur le câble. L'étape 302 permet d'éviter de réaliser une analyse complète du réflectogramme.

L'étape 303 consiste ensuite à déterminer des zones d'analyse autour des extrema détectés à l'étape précédente 302. Autrement dit, l'étape 303 consiste à définir une fenêtre temporelle autour de chaque extrema sur laquelle les étapes suivantes du procédé vont être appliquées.

Selon un exemple de réalisation, l'étape 303 est réalisée en définissant les bornes de la fenêtre temporelle à partir du calcul de la largeur de l'impulsion à une certaine hauteur relative de la proéminence de l'impulsion. Sur l'exemple de la figure 5, la zone d'analyse 501 est déterminée de sorte que la largeur de l'impulsion est mesurée à 80% de la proéminence, c'est-à-dire la hauteur totale de l'impulsion mesurée entre l'extremum et la base de l'impulsion. Le pourcentage peut être choisi à une valeur différente mais résulte d'un compromis entre la précision recherchée et le taux de fausse détection toléré. Un pourcentage plus faible entraine une précision moindre, un pourcentage plus élevé entraine un risque de fausse détection après analyse.

L'étape 303 est par exemple mise en oeuvre au moyen d'un calcul de proéminence qui consiste à déterminer de part et d'autre de l'extrema, les minima locaux du signal qui définissent la base du signal puis à mesurer la proéminence égale à la distance entre l'extrema et le minimum local le plus élevé parmi les deux points qui définissent la base du signal. Ensuite la zone d'analyse est définie en traçant la largeur de l'impulsion à une distance de l'extremum égale à 80% de la proéminence.

L'étape 303 est réalisée pour chaque impulsion associée à un extremum détecté à l'étape 302.

L'étape 304 consiste ensuite à analyser chaque impulsion dans sa zone d'analyse afin de déterminer s'il s'agit d'une impulsion simple ou d'une impulsion résultant de la combinaison de plusieurs autres impulsions.

En effet, l'un des problèmes à résoudre pour réaliser une analyse automatique d'un réflectogramme concerne les impulsions qui se superposent et se combinent car elles résultent de réflexions du signal sur des discontinuités d'impédance qui sont proches sur le câble ou de combinaison avec des réflexions multiples du signal. Ainsi, chaque impulsion détectée sur le réflectogramme ne correspond pas forcément à une réflexion simple du signal d'excitation mais peut souvent résulter d'une combinaison de plusieurs réflexions, rendant alors l'interprétation directe de la signature temporelle complexe.

L'étape 304 consiste à identifier pour chaque impulsion du réflectogramme si elle résulte d'une combinaison de deux impulsions successives qui influent mutuellement l'une sur l'autre en se superposant partiellement.

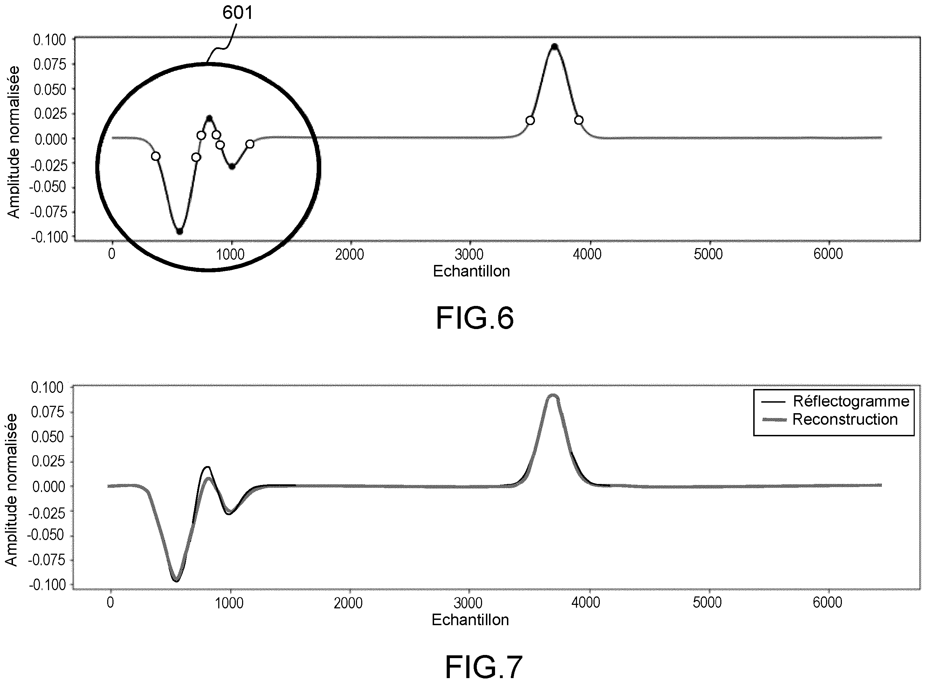

Sur l'exemple de la figure 6, la zone 601 du réflectogramme correspond à une superposition de plusieurs impulsions. En effet, sur cet exemple, un défaut non franc est situé au début du câble. Les impulsions Gaussiennes correspondant à la réflexion du signal sur le défaut non franc se combinent avec celle qui correspond à la désadaptation d'impédance entre l'appareil de mesure et le câble, au début du câble.

Cette combinaison implique que les impulsions présentes dans la zone 601 ne possèdent plus les mêmes caractéristiques que le signal d'excitation qui est un signal Gaussien dans cet exemple. On peut voir sur la figure 6 que la signature temporelle du défaut non franc diffère de l'attendu car en général un défaut non franc est caractérisé par deux impulsions Gaussiennes successives quasi identiques mais en opposition de phase ce qui n'est pas le cas sur la figure 6.

Ainsi, il est nécessaire de déterminer si une impulsion correspond à une superposition ou une combinaison de plusieurs autres impulsions afin de déterminer les impulsions qui sont à l'origine de la combinaison éventuelle. C'est l'objet de l'étape 304 de la méthode d'analyse.

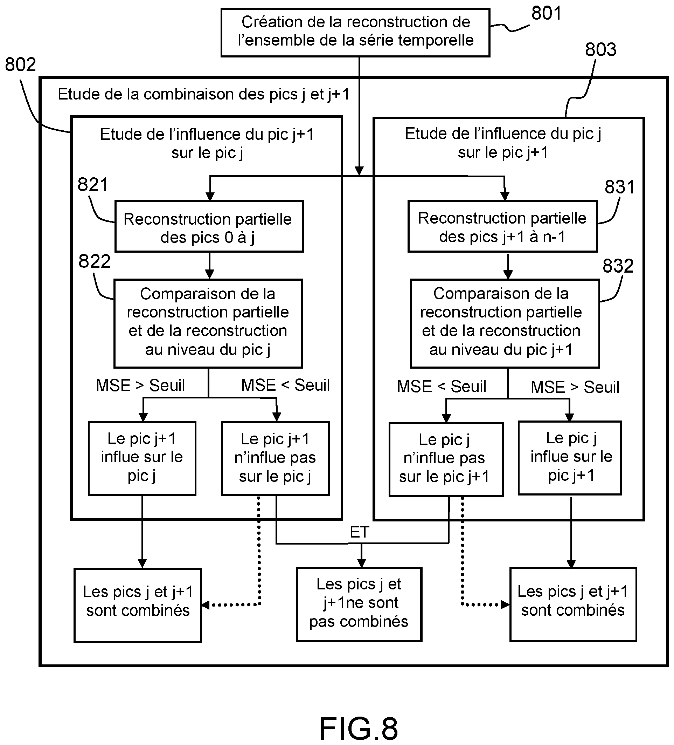

La figure 8 représente un logigramme des sous-étapes de réalisation de l'étape 304 de détection d'impulsions combinées.

A l'étape 801, on détermine tout d'abord une reconstruction totale de l'ensemble du réflectogramme sous la forme d'une série temporelle correspondant à la somme des impulsions qui ont la même position et la même amplitude que les impulsions détectées sur le réflectogramme. Cette série temporelle reconstruite permet de modéliser et de simplifier le réflectogramme initial.

La série temporelle reconstruite est obtenue en générant, pour chaque extremum du réflectogramme identifié à l'étape 302, une impulsion ayant la même forme que le signal d'excitation. Sur l'exemple de la figure 7, on a représenté la série temporelle reconstruite obtenue pour le réflectogramme de la figure 4.

Pour cet exemple, le signal d'excitation est un signal Gaussien, alors chaque impulsion Gaussienne de la série temporelle reconstruite est obtenue par exemple à l'aide de la formule suivante : $A \times e^{\frac{-1}{2}\left(\frac{t-b}{a}\right)^2}$ .

avec A, l'amplitude de l'impulsion mesurée sur le réflectogramme, c'est-à-dire la valeur de chaque extremum,

$$a = \frac{1}{f} \times \frac{1}{2 \times \sqrt{2 \times ln(2)}}$$

représente un facteur de dilatation, f est la fréquence maximale du signal d'excitation,

b est égal à l'index de l'extremum multiplié par la période d'échantillonnage du signal et représente la translation temporelle de l'impulsion.

L'impulsion de la série reconstruite est générée au moyen de la formule ci-dessus dans la zone d'analyse déterminée à l'étape 303.

Sans sortir du cadre de l'invention, la forme du signal d'excitation peut être différente du forme Gaussienne, dans ce cas, la fonction de modélisation utilisée pour reconstruire les impulsions prend en compte la forme du signal d'excitation.

L'algorithme décrit à la figure 8 s'applique ensuite pour chaque couple d'impulsions successives d'indices j et j+1 identifiées sur le réflectogramme.

A l'étape 802, on analyse l'influence potentielle de l'impulsion d'indice j+1 sur l'impulsion d'indice j puis à l'étape 803 on fait l'opération inverse en analysant l'influence potentielle de l'impulsion d'indice j sur l'impulsion d'indice j+1.

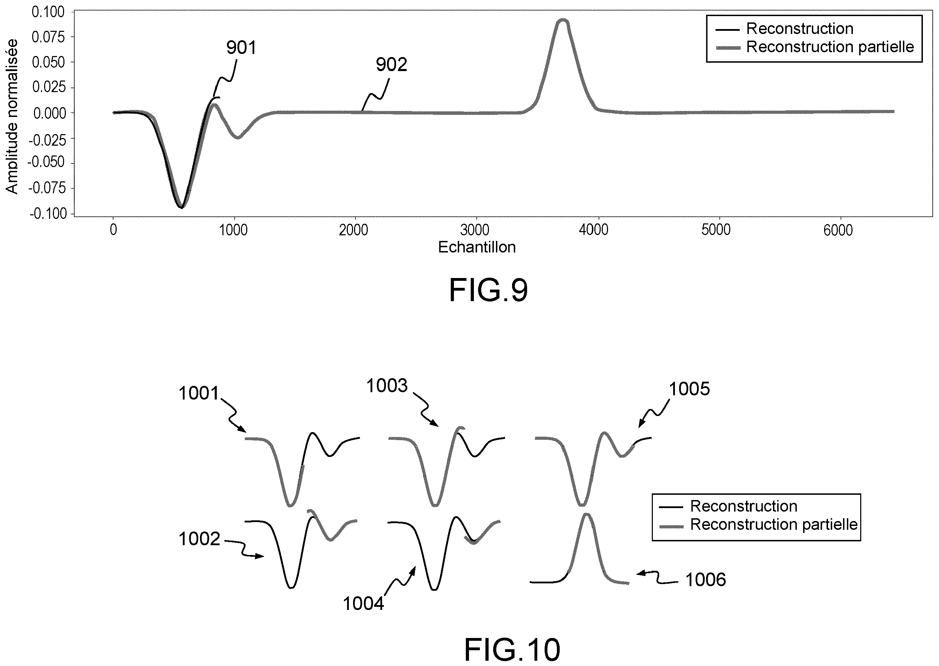

A l'étape 821, on construit une reconstruction partielle du réflectogramme correspondant à la somme de la première partie des impulsions allant de l'indice 0 (première impulsion) à l'indice j. Cette reconstruction partielle 901 est représentée sur l'exemple de la figure 9 en comparaison avec la reconstruction totale 902. La reconstruction partielle permet de simuler une impulsion d'indice j tout en conservant potentiellement l'influence qu'exercent les impulsions précédentes sur lui mais en ignorant l'influence des impulsions suivantes. L'objectif est d'analyser l'impulsion d'indice j en l'absence de l'influence de l'impulsion suivante d'indice j+1.

On voit sur la figure 9 que les deux reconstructions 901,902 diffèrent au niveau du second pic (j=1 pour cet exemple).

A l'étape 822, une comparaison est réalisée entre la reconstruction partielle 901 et de la reconstruction totale 902 dans la fenêtre d'analyse de l'impulsion d'indice j. Si les deux reconstructions sont similaires dans la zone d'analyse, cela signifie que l'impulsion d'indice j+1 n'influe pas sur l'impulsion d'indice j, dans le cas contraire cela signifie donc que l'impulsion d'indice j+1 a une influence sur l'impulsion d'indice j.

La comparaison entre les deux reconstructions peut être réalisée en calculant un critère d'erreur entre les deux reconstructions dans la zone d'analyse, par exemple un critère d'erreur quadratique moyenne, puis en comparant le résultat à un seuil d'erreur prédéterminé. Ce seuil d'erreur est par exemple de l'ordre de 1e-09. Sa valeur est déterminée en fonction du cas d'application.

Les mêmes traitements sont réalisés à l'étape 803 pour évaluer l'influence de l'impulsion d'indice j sur l'impulsion d'indice j+1. Pour cela on détermine à l'étape 831 une reconstruction partielle du réflectogramme pour les impulsions allant de l'indice j+1 à l'indice N-1 où N est le nombre d'impulsions du réflectogramme.

A l'étape 832 on effectue une comparaison entre cette reconstruction partielle et la reconstruction totale dans la fenêtre d'analyse de l'impulsion d'indice j+1. Si les deux reconstructions sont similaires dans la zone d'analyse, cela signifie que l'impulsion d'indice j n'influe pas sur l'impulsion d'indice j+1, dans le cas contraire cela signifie donc que l'impulsion d'indice j a une influence sur l'impulsion d'indice j+1.

Enfin, on arrive à la conclusion que les impulsions j et j+1 sont combinées si au moins l'une des deux impulsions influe sur l'autre, dans le cas contraire, ces deux impulsions ne sont pas combinées.

La figure 10 illustre le fonctionnement de l'algorithme de la figure 8 sur un exemple comprenant les quatre impulsions d'indices 401, 402, 403, 404 du réflectogramme de la figure 4.

Les diagrammes 1001 et 1002 montrent respectivement la comparaison des reconstructions partielles et totales pour l'analyse d'influence réciproque des impulsions 401,402. On peut voir que ces deux impulsions sont combinées puisque l'impulsion 401 exerce de l'influence sur l'impulsion 402 (écart entre les deux courbes sur le diagramme 1002).

Les diagrammes 1003 et 1004 montrent respectivement la comparaison des reconstructions partielles et totales pour l'analyse d'influence réciproque des impulsions 402,403. On peut voir que ces deux impulsions sont combinées puisque l'impulsion 402 exerce de l'influence sur l'impulsion 403 et réciproquement (écart entre les deux courbes sur le diagramme 1003 et sur le diagramme 1004).

Les diagrammes 1005 et 1006 montrent respectivement la comparaison des reconstructions partielles et totales pour l'analyse d'influence réciproque des impulsions 403,404. Cette fois, ces deux impulsions ne sont pas combinées puisqu'aucune des deux n'influe sur l'autre comme cela peut être vu sur les deux diagrammes 1005 et 1006 qui montrent des courbes superposées.

On revient à l'organigramme de la figure 3. A l'issue de l'étape 304, on sait, pour chaque impulsion du réflectogramme si il s'agit d'une impulsion simple ou d'une impulsion combinée avec une autre.

Dans le cas où l'impulsion est simple, on passe à l'étape 305 pour réaliser un test de similarité entre l'impulsion du réflectogramme initial et l'impulsion correspondante de la série temporelle reconstruite à l'étape 801, dans la zone d'analyse de l'impulsion. Le test de similarité est réalisé en comparant les deux impulsions par exemple en calculant un critère d'erreur adéquat entre les deux impulsions et en le comparant à un seuil d'erreur prédéterminé. Le critère d'erreur est par exemple un critère d'erreur quadratique moyenne avec une étape préalable de normalisation entre -1 et 1 des valeurs des deux séries temporelles à comparer en les divisant par l'extremum du réflectogramme mesuré. La valeur du seuil d'erreur est par exemple de l'ordre de 1e-03 et par exemple égale à $3.5^e$-03. Sa valeur est déterminée en fonction du cas d'application.

Ensuite, à l'étape 306, on réalise une classification de l'impulsion afin de l'associer à un type de discontinuité d'impédance.

Si le critère d'erreur est supérieur au seuil d'erreur alors cela signifie que la portion de la série temporelle analysée n'a pas la même forme que le signal d'excitation puisque la série reconstruite est une somme d'impulsions Gaussiennes de même fréquence maximale que le signal d'excitation. Dans ce cas, l'impulsion n'est pas classifiée afin d'éviter un faux positif.

Dans le cas contraire, on attribue une classe à l'impulsion simple en fonction de son abscisse temporelle et de la valeur de son extremum. Par exemple, les classes suivantes peuvent être considérées. Si l'amplitude normalisée de l'extremum est proche de -1, la désadaptation d'impédance correspond à un court-circuit. Si l'amplitude normalisée de l'extremum est proche de 1, la désadaptation d'impédance correspond à un circuit ouvert. D'autres classes peuvent être considérées, par exemple une classe regroupant les impédances caractéristiques proches de celles du câble à analyser ou une classe associant systématiquement la première discontinuité d'impédance à la désadaptation d'impédance provoquée par la différence d'impédance du port de mesure par rapport à celui du câble.

A ce stade, on ne peut pas encore identifier un défaut non franc puisqu'il est toujours caractérisé par un ensemble de deux pics successifs en opposition de phase.

Dans le cas où une impulsion combinée est détectée à l'étape 304, on passe à l'étape 307 pour déterminer la position et l'amplitude des impulsions qui sont à l'origine de la combinaison. Pour cela, un algorithme d'optimisation est mis en oeuvre pour obtenir une reconstruction optimisée à partir de la reconstruction partielle des impulsions d'un groupe d'impulsions combinées.

Autrement dit, à l'issue de l'étape 304 on regroupe les impulsions successives qui ont été détectées comme étant combinées puis on leur applique un algorithme d'optimisation qui a pour objectif de faire varier l'amplitude et la position des extrema afin d'approcher au mieux le réflectogramme d'origine. De cette façon on obtient une reconstruction partielle optimisée dont les amplitudes et les positions des extrema sont modifiées.

Autrement dit, on recherche les positions et amplitudes des pics qui sont à l'origine de la combinaison.

La fonction d'optimisation utilisée cherche à déterminer les valeurs d'amplitude et de position de chacun des pics du groupe qui minimisent la différence entre le réflectogramme d'origine et une certaine reconstruction qui est définie par ces valeurs. Cette fonction prend donc comme entrées l'amplitude et la position de chacun des pics du groupe ainsi que l'ensemble des éléments nécessaires au calcul de la différence des deux courbes. Ces éléments sont la fonction à minimiser et la série extraite du réflectogramme (morceau du réflectogramme définie par les bornes des pics du groupe). Optionnellement, il est possible d'instaurer des contraintes sur les valeurs d'amplitudes et de positions pour rendre la résolution de l'optimisation plus efficace.

L'algorithme d'optimisation utilisé est par exemple un algorithme à régions de confiance ou algorithme « trust région reflective » en anglais qui est décrit par exemple dans les références [4], [5] et [6].

L'étape d'optimisation 307 permet notamment d'affiner la précision des positions temporelles des extrema afin d'en déduire ultérieurement une estimation précise de la position des défauts sur le câble.

En sortie de l'étape 307, on obtient une reconstruction partielle optimisée pour chaque groupe de pics combinés.

A l'étape 308, on réalise ensuite un test de similarité identique à celui de l'étape 305 qui consiste à vérifier la similarité entre la reconstruction partielle optimisée et le réflectogramme d'origine. Pour cela on utilise le même critère d'erreur qu'à l'étape 305 associé à un seuil d'erreur différent. La valeur du seuil d'erreur est par exemple de l'ordre de 1.5$^e$-03.

Si le critère d'erreur est supérieur au seuil d'erreur, cela peut signifier que l'optimisation réalisée à l'étape 307 n'est pas valide ou bien que les impulsions analysées n'ont pas la même forme que le signal d'excitation. Cet échec d'optimisation peut venir du fait qu'il manque peut-être certaines informations sur des contributions d'impulsions « cachées » dans la somme des impulsions. Dans ce cas, les pics du groupe de pics combinés ne sont pas classifiés.

Dans le cas inverse, on effectue à l'étape 309 un test sur chaque couple successif de pics du groupe de pics pour vérifier s'ils correspondent à la signature temporelle d'un défaut non franc. Pour cela, on vérifie que deux pics successifs ont sensiblement la même amplitude et sont de signes opposés. Si cela est le cas, on regroupe les deux pics pour les associer à un défaut non franc à l'étape 310.

Si ce n'est pas le cas, on retourne à l'étape 306 pour classifier les impulsions simples.

La méthode est réalisée pour l'ensemble des extrema du réflectogramme. Lorsque tout le réflectogramme est analysé, on convertit la position temporelle de chaque impulsion en distance correspondant à la position du défaut ou de la discontinuité d'impédance sur le câble. Cette opération est réalisée à partir de la période d'échantillonnage et de la vitesse de propagation de l'onde injectée dans le câble.

Enfin, à l'étape 311, le réflectogramme est affichée sur une interface utilisateur avec les informations associées aux défauts et discontinuités d'impédance détectées notamment leurs positions et types associées aux classifications réalisées aux étapes 306 et 310.

L'invention peut être mise en oeuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en oeuvre des aspects des techniques décrites ici. Les moyens ou ressources informatiques peuvent notamment être distribués *("Cloud computing")*, éventuellement selon des technologies de pair-à-pair. Le code logiciel peut être exécuté sur n'importe quel processeur approprié (par exemple, un microprocesseur) ou coeur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en oeuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

L'invention peut aussi être implémentée sous forme embarquée dans un dispositif de réflectométrie tel que décrit aux figures 1a et 1b. Dans ce cas, le dispositif comporte une unité de traitement de type ordinateur, assistant numérique personnel ou autre pour piloter le système de réflectométrie et exécuter la méthode selon l'invention et afficher les résultats produits par la méthode sur une interface homme-machine.

Références

[1] Salama MEGHRICHE, « Reconnaissance de Forme de Signaux Biologiques », mémoire de thèse, 2008.

[2] Felix Scholkmann, Jens Boss and Martin Wolf, « An Efficient Algorithm for Automatic Peak Detection in Noisy Periodic and Quasi-Periodic Signals », Algorithms 2012, 5, 588-603.

[3] Samir OUELHA, « Représentation et reconnaissance des signaux acoustiques sous-marins », mémoire de thèse, 2014.

[4] M. A. Branch, T. F. Coleman, and Y. Li, "A Subspace, Interior, and Conjugate Gradient Method for Large-Scale Bound-Constrained Minimization Problems," SIAM Journal on Scientific Computing, Vol. 21, Number 1, pp 1-23, 1999.

[5] J. J. More, "The Levenberg-Marquardt Algorithm: Implementation and Theory," Numerical Analysis, ed. G. A. Watson, Lecture Notes in Mathematics 630, Springer Verlag, pp. 105-116, 1977.

[6] R. H. Byrd, R. B. Schnabel and G. A. Shultz, "Approximate solution of the trust région problem by minimization over two-dimensional subspaces", Math. Programming, 40, pp. 247-263, 1988.

**Revendications**

1. Méthode d'évaluation d'une ligne de transmission, par réflectométrie, comprenant les étapes de :

   - Obtenir (301) une mesure de la réponse impulsionnelle temporelle d'un signal de référence propagé dans la ligne à partir d'un point d'injection puis rétro-propagé en un point de mesure, la mesure temporelle, appelée réflectogramme, comprenant une pluralité de pics d'amplitude correspondant chacun à une discontinuité d'impédance,
   - Rechercher (302) un ensemble d'extrema locaux du réflectogramme,
   - Déterminer (801) une reconstruction totale du réflectogramme comme étant la somme d'impulsions ayant chacune la forme du signal de référence et la position et l'amplitude desdits extrema locaux,

**caractérisée en ce que** la méthode comprend en outre les étapes suivantes:

   - Pour chaque couple d'extrema locaux successifs d'indices j et j+1, comparer (822,832) la reconstruction totale avec, respectivement, une première reconstruction partielle (821) du réflectogramme pour les extrema locaux d'indices 0 à j et une seconde reconstruction partielle (831) du réflectogramme pour les extrema locaux d'indices j+1 à N-1, N étant le nombre d'extrema locaux, pour déterminer (802,803) si les impulsions d'indices j et j+1 du réflectogramme influent mutuellement l'une sur l'autre ou non,
   - Pour un groupe d'impulsions du réflectogramme influant mutuellement les unes sur les autres, déterminer (307) une reconstruction optimisée du groupe d'impulsions à partir d'une reconstruction partielle des impulsions du groupe de sorte à modifier les abscisses des impulsions de la reconstruction partielle pour minimiser un critère d'erreur entre la reconstruction partielle optimisée et le réflectogramme mesuré,
   - Comparer (308) la différence entre la reconstruction partielle optimisée et le réflectogramme mesuré à un premier seuil d'erreur et si la différence est inférieure au premier seuil d'erreur, classifier (309,306,310) la discontinuité d'impédance associée à chaque impulsion du groupe d'impulsions en fonction de sa position et de son amplitude parmi les classes suivantes : un défaut non franc, un court-circuit, un circuit ouvert, une charge adaptée à la charge de la ligne de transmission, une désadaptation d'impédance entre le port de mesure et la ligne de transmission.

2. Méthode d'évaluation d'une ligne de transmission selon la revendication 1 dans laquelle la forme du signal de référence est une impulsion Gaussienne.

3. Méthode d'évaluation d'une ligne de transmission selon l'une quelconque des revendications précédentes dans laquelle l'étape de déterminer si les impulsions d'indices j et j+1 du réflectogramme influent mutuellement l'une sur l'autre ou non comprend les sous étapes de :

   - Comparer (822) une première différence entre la première reconstruction partielle et la reconstruction totale à un second seuil d'erreur,
   - Comparer (832) une seconde différence entre la seconde reconstruction partielle et la reconstruction totale au second seuil d'erreur,
   - Si au moins l'une des différences parmi la première différence ou la seconde différence est supérieure au second seuil d'erreur, en déduire que les impulsions d'indices j et j+1 du réflectogramme influent mutuellement l'une sur l'autre, sinon en déduire qu'elles sont indépendantes.

4. Méthode d'évaluation d'une ligne de transmission selon l'une quelconque des revendications précédentes comprenant l'étape de :

- Pour les impulsions du réflectogramme identifiées comme indépendantes, comparer (305) la différence entre le réflectogramme et la reconstruction totale, dans une fenêtre temporelle encadrant l'impulsion, à un troisième seuil d'erreur,
- Si la différence est inférieure au troisième seuil d'erreur, classifier (306) la désadaptation d'impédance correspondant à l'impulsion en fonction de sa position et de son amplitude parmi les classes suivantes : un court-circuit, un circuit ouvert, une charge adaptée à la charge de la ligne de transmission, une désadaptation d'impédance entre le port de mesure et la ligne de transmission.

5. Méthode d'évaluation d'une ligne de transmission selon l'une quelconque des revendications précédentes dans laquelle la reconstruction optimisée (307) est obtenue au moyen d'un algorithme à régions de confiance.

6. Méthode d'évaluation d'une ligne de transmission selon la revendication 4 comprenant l'étape de, si la différence entre la reconstruction partielle optimisée et le réflectogramme mesuré est inférieure au premier seuil d'erreur pour deux impulsions successives, déterminer (309) si les deux impulsions sont d'amplitudes sensiblement identiques et de signes opposés et si oui, classifier la désadaptation d'impédance correspondant à ces deux impulsions comme résultant d'un défaut non franc, si non classifier (306) la désadaptation d'impédance correspondant à chacune des deux impulsions en fonction de sa position et de son amplitude parmi les classes suivantes : un court-circuit, un circuit ouvert, une charge adaptée à la charge de la ligne de transmission, une désadaptation d'impédance entre le port de mesure et la ligne de transmission.

7. Méthode d'évaluation d'une ligne de transmission selon l'une quelconque des revendications précédentes comprenant en outre une étape d'extraction (303) de chaque impulsion associée à un extremum du réflectogramme, dans un intervalle temporel de largeur choisie telle que la distance entre le sommet de l'impulsion et ladite largeur est égale à un pourcentage prédéterminé, par exemple au moins égal à 80%, de la hauteur totale de l'impulsion.

8. Méthode d'évaluation d'une ligne de transmission selon l'une quelconque des revendications précédentes dans laquelle le réflectogramme mesuré est normalisé en amplitude entre -1 et 1.

9. Méthode d'évaluation d'une ligne de transmission selon l'une quelconque des revendications précédentes dans laquelle, avant la comparaison avec le premier seuil d'erreur ou le troisième seuil d'erreur, le réflectogramme et la reconstruction partielle optimisée ou totale sont normalisées par rapport à l'extremum du réflectogramme.

10. Méthode d'évaluation d'une ligne de transmission selon l'une quelconque des revendications précédentes comprenant en outre une étape de détermination des positions des discontinuités d'impédance à partir des abscisses temporelles des extrema du réflectogramme et une étape d'affichage (311) des positions et types des discontinuités d'impédance sur une interface homme machine.

11. Programme d'ordinateur comportant des instructions pour l'exécution de la méthode selon l'une quelconque des revendications précédentes, lorsque le programme est exécuté par un processeur.

12. Support d'enregistrement lisible par un processeur sur lequel est enregistré un programme comportant des instructions pour l'exécution de la méthode selon l'une quelconque des revendications 1 à 10, lorsque le programme est exécuté par un processeur.

**Patentansprüche**

1. Verfahren zum Bewerten einer Übertragungsleitung durch Reflektometrie, das die folgenden Schritte umfasst:

- Erhalten (301) eines Messwerts der zeitlichen Impulsantwort eines Referenzsignals, das sich in der Leitung von einem Einspeisepunkt aus ausbreitet und dann zu einem Messpunkt zurückgeführt wird, wobei der zeitliche Messwert, Reflektogramm genannt, eine Vielzahl von Amplitudenspitzen umfasst, die jeweils einer Impedanzdiskontinuität entsprechen,
- Suchen (302) nach einem Satz von lokalen Extrema des Reflektogramms,
- Bestimmen (801) einer Gesamtrekonstruktion des Reflektogramms als die Summe von Impulsen, die jeweils die Form des Referenzsignals und die Position und Amplitude der lokalen Extrema aufweisen,

**dadurch gekennzeichnet, dass** das Verfahren ferner die folgenden Schritte umfasst:

- Vergleichen (822, 832), für jedes Paar von aufeinanderfolgenden lokalen Extrema mit den Indizes j und j + 1, der Gesamtrekonstruktion mit jeweils einer ersten Teilrekonstruktion (821) des Reflektogramms für die lokalen Extrema mit den Indizes 0 bis j und einer zweiten Teilrekonstruktion (831) des Reflektogramms für die lokalen Extrema mit den Indizes j + 1 bis N - 1, wobei N die Anzahl der lokalen Extrema ist, um festzustellen (802, 803), ob die Impulse mit den Indizes j und j + 1 des Reflektogramms sich gegenseitig beeinflussen oder nicht,

- Bestimmen (307), für eine Gruppe von Impulsen des Reflektogramms, die sich gegenseitig beeinflussen, einer optimierten Rekonstruktion der Gruppe von Impulsen aus einer Teilrekonstruktion der Impulse der Gruppe, so dass die Abszissen der Impulse der Teilrekonstruktion geändert werden, um ein Fehlerkriterium zwischen der optimierten Teilrekonstruktion und dem gemessenen Reflektogramm zu minimieren,

- Vergleichen (308) der Differenz zwischen der optimierten Teilrekonstruktion und dem gemessenen Reflektogramm mit einem ersten Fehlerschwellenwert und Klassifizieren (309, 306, 310), wenn die Differenz kleiner ist als der erste Fehlerschwellenwert, der mit jedem Impuls der Gruppe von Impulsen assoziierten Impedanzdiskontinuität in Abhängigkeit von ihrer Position und Amplitude unter den folgenden Klassen: einem nicht offenkundigen Fehler, einem Kurzschluss, einem offenen Stromkreis, einer an die Last der Übertragungsleitung angepassten Last, einer Impedanzfehlanpassung zwischen dem Messanschluss und der Übertragungsleitung.

2. Verfahren zum Bewerten einer Übertragungsleitung nach Anspruch 1, wobei die Form des Referenzsignals ein Gaußscher Impuls ist.

3. Verfahren zum Bewerten einer Übertragungsleitung nach einem der vorhergehenden Ansprüche, wobei der Schritt des Feststellens, ob die Impulse mit den Indizes j und j + 1 des Reflektogramms sich gegenseitig beeinflussen oder nicht, die folgenden Teilschritte umfasst:

- Vergleichen (822) einer ersten Differenz zwischen der ersten Teilrekonstruktion und der Gesamtrekonstruktion mit einem zweiten Fehlerschwellenwert,
- Vergleichen (832) einer zweiten Differenz zwischen der zweiten Teilrekonstruktion und der Gesamtrekonstruktion mit dem zweiten Fehlerschwellenwert,
- Folgern, wenn mindestens eine der Differenzen aus der ersten Differenz und der zweiten Differenz größer als der zweite Fehlerschwellenwert ist, dass die Impulse mit den Indizes j und j + 1 des Reflektogramms sich gegenseitig beeinflussen, andernfalls Folgern, dass sie unabhängig voneinander sind.

4. Verfahren zum Bewerten einer Übertragungsleitung nach einem der vorhergehenden Ansprüche, das den folgenden Schritt umfasst:

- Vergleichen (305), für die als unabhängig identifizierten Impulse des Reflektogramms, der Differenz zwischen dem Reflektogramm und der Gesamtrekonstruktion innerhalb eines Zeitfensters, das den Impuls umgibt, mit einem dritten Fehlerschwellenwert,
- Klassifizieren (306), wenn die Differenz kleiner ist als der dritte Fehlerschwellenwert, der dem Impuls entsprechenden Impedanzfehlanpassung je nach ihrer Position und Amplitude aus den folgenden Klassen: Kurzschluss, offener Stromkreis, an die Last der Übertragungsleitung angepasste Last, Impedanzfehlanpassung zwischen dem Messanschluss und der Übertragungsleitung.

5. Verfahren zum Bewerten einer Übertragungsleitung nach einem der vorhergehenden Ansprüche, wobei die optimierte Rekonstruktion (307) mittels eines Algorithmus mit vertrauenswürdigen Regionen erhalten wird.

6. Verfahren zum Bewerten einer Übertragungsleitung nach Anspruch 4, das den Schritt des Feststellens (309), wenn die Differenz zwischen der optimierten Teilrekonstruktion und dem gemessenen Reflektogramm für zwei aufeinanderfolgende Impulse unter dem ersten Fehlerschwellenwert liegt, ob die beiden Impulse im Wesentlichen identische Amplituden und entgegengesetzte Vorzeichen haben, und wenn ja, des Klassifizierens der diesen beiden Impulsen entsprechenden Impedanzfehlanpassung als Folge eines nicht offenkundigen Fehlers, wenn nicht, des Klassifizierens (306) der jedem der beiden Impulse entsprechenden Impedanzfehlanpassung in Abhängigkeit von ihrer Position und Amplitude unter den folgenden Klassen umfasst: Kurzschluss, offener Stromkreis, an die Last der Übertragungsleitung angepasste Last, Impedanzfehlanpassung zwischen dem Messanschluss und der Übertragungsleitung.

7. Verfahren zum Bewerten einer Übertragungsleitung nach einem der vorhergehenden Ansprüche, das ferner einen Schritt des Extrahierens (303) jedes mit einem Extremum des Reflektogramms assoziierten Impulses in einem Zeitintervall mit einer Breite umfasst, die so ausgewählt ist, dass der Abstand zwischen dem Scheitelpunkt des Impulses und der Breite gleich einem vorbestimmten Prozentsatz, beispielsweise mindestens gleich 80%, der Gesamthöhe des Impulses ist.

8. Verfahren zum Bewerten einer Übertragungsleitung nach einem der vorhergehenden Ansprüche, wobei das gemessene Reflektogramm in der Amplitude zwischen -1 und 1 normalisiert wird.

9. Verfahren zum Bewerten einer Übertragungsleitung nach einem der vorhergehenden Ansprüche, wobei vor dem Vergleich mit dem ersten Fehlerschwellenwert oder dem dritten Fehlerschwellenwert das Reflektogramm und die optimierte Teil- oder Gesamtrekonstruktion auf das Extremum des Reflektogramms normalisiert werden.

10. Verfahren zum Bewerten einer Übertragungsleitung nach einem der vorhergehenden Ansprüche, das außerdem einen Schritt des Bestimmens der Positionen der Impedanzdiskontinuitäten aus den zeitlichen Abszissen der Extrema des Reflektogramms und einen Schritt des Anzeigens (311) der Positionen und Typen der Impedanzdiskontinuitäten auf einer Mensch-Maschine-Schnittstelle umfasst.

11. Computerprogramm, das Befehle zur Ausführung des Verfahrens nach einem der vorhergehenden Ansprüche umfasst, wenn das Programm von einem Prozessor ausgeführt wird.

12. Prozessorlesbares Aufzeichnungsmedium, auf dem ein Programm mit Befehlen zur Ausführung des Verfahrens nach einem der Ansprüche 1 bis 10 aufgezeichnet ist, wenn das Programm von einem Prozessor ausgeführt wird.

## Claims

1. A method for evaluating a transmission line by reflectometry, comprising the following steps of:

  - acquiring (301) a measurement of the temporal impulse response of a reference signal propagated through the line from an injection point and then back-propagated at a measurement point, with the temporal measurement, called reflectogram, comprising a plurality of amplitude peaks each corresponding to an impedance discontinuity;
  - searching (302) for a set of local extrema of the reflectogram;
  - determining (801) a complete reconstruction of the reflectogram as being the sum of pulses each assuming the shape of the reference signal and the position and the amplitude of said local extrema;

  **characterised in that** the method further comprises the following steps of:

  - comparing (822, 832), for each pair of successive local extrema of indices j and j + 1, the complete reconstruction with, respectively, a first partial reconstruction (821) of the reflectogram for the local extrema of indices 0 to j and a second partial reconstruction (831) of the reflectogram for the local extrema of indices j + 1 to N - 1, with N being the number of local extrema, in order to determine (802, 803) whether or not the pulses of indices j and j + 1 of the reflectogram mutually influence one another;
  - determining (307), for a group of pulses of the reflectogram mutually influencing one another, an optimised reconstruction of the group of pulses based on a partial reconstruction of the pulses of the group so as to modify the abscissas of the pulses of the partial reconstruction to minimise an error criterion between the optimised partial reconstruction and the measured reflectogram;
  - comparing (308) the difference between the optimised partial reconstruction and the measured reflectogram with a first error threshold and, if the difference is less than the first error threshold, classifying (309, 306, 310) the impedance discontinuity associated with each pulse of the group of pulses as a function of its position and its amplitude among the following classes: a soft fault, a short circuit, an open circuit, a load matched to the load of the transmission line, an impedance mismatch between the measurement port and the transmission line.

2. The method for evaluating a transmission line according to claim 1, wherein the shape of the reference signal is a Gaussian pulse.

3. The method for evaluating a transmission line according to any one of the preceding claims, wherein the step of determining whether or not the pulses of indices j and j + 1 of the reflectogram mutually influence one another comprises the sub-steps of:

  - comparing (822) a first difference between the first partial reconstruction and the complete reconstruction with a second error threshold;
  - comparing (832) a second difference between the second partial reconstruction and the complete reconstruction with the second error threshold;
  - deducing, if at least one of the differences from among the first difference or the second difference is greater than the second error threshold, that the pulses of indices j and j + 1 of the reflectogram mutually influence one another, otherwise deducing that they are independent.

4. The method for evaluating a transmission line according to any one of the preceding claims, comprising the steps of

- comparing (305), for the pulses of the reflectogram that are identified as being independent, the difference between the reflectogram and the complete reconstruction, within a temporal window encapsulating the pulse, with a third error threshold;
- classifying (306), if the difference is less than the third error threshold, the impedance mismatch corresponding to the pulse as a function of its position and its amplitude among the following classes: a short circuit, an open circuit, a load matched to the load of the transmission line, an impedance mismatch between the measurement port and the transmission line.

5. The method for evaluating a transmission line according to any one of the preceding claims, wherein the optimised reconstruction (307) is acquired by means of a confidence region algorithm.

6. The method for evaluating a transmission line according to claim 4, comprising the step of determining (309), if the difference between the optimised partial reconstruction and the measured reflectogram is less than the first error threshold for two successive pulses, whether the two pulses have substantially identical amplitudes and opposite signs and, if so, classifying the impedance mismatch corresponding to these two pulses as resulting from a soft fault, and, if not, classifying (306) the impedance mismatch corresponding to each of the two pulses as a function of its position and its amplitude among the following classes: a short circuit, an open circuit, a load matched to the load of the transmission line, an impedance mismatch between the measurement port and the transmission line.

7. The method for evaluating a transmission line according to any one of the preceding claims, further comprising a step of extracting (303) each pulse associated with an extremum of the reflectogram, within a time interval with a width that is selected such that the distance between the vertex of the pulse and said width is equal to a predetermined percentage, for example, at least equal to 80 %, of the total height of the pulse.

8. The method for evaluating a transmission line according to any one of the preceding claims, wherein the measured reflectogram is amplitude normalised between -1 and 1.

9. The method for evaluating a transmission line according to any one of the preceding claims, wherein, before the comparison with the first error threshold or the third error threshold, the reflectogram and the optimised partial or complete reconstruction are normalised with respect to the extremum of the reflectogram.

10. The method for evaluating a transmission line according to any one of the preceding claims, further comprising a step of determining the positions of the impedance discontinuities based on the temporal abscissas of the extrema of the reflectogram and a step of displaying (311) the positions and types of the impedance discontinuities on a human-machine interface.

11. A computer program comprising instructions for executing the method according to any one of the preceding claims, when the program is executed by a processor.

12. A processor-readable storage medium storing a program comprising instructions for executing the method according to any one of claims 1 to 10, when the program is executed by a processor.

FIG.1a

FIG.1b

FIG.2

Acquisition réflectogramme — 301

Recherche extrema — 302

Détermination zones d'analyse — 303

Détection impulsions combinés — 304

Impulsion simple

Impulsions combinées

Test similarité — 305

Optimisation reconstruction — 307

Classification impulsions simples — 306

Test similarité — 308

Test défaut non franc — 309

Classification défauts non francs — 310

Affichage — 311

FIG.3

FIG.4

FIG.5

FIG.6

FIG.7

Création de la reconstruction de l'ensemble de la série temporelle — 801

802

803

Etude de la combinaison des pics j et j+1

Etude de l'influence du pic j+1 sur le pic j

821

Reconstruction partielle des pics 0 à j

822

Comparaison de la reconstruction partielle et de la reconstruction au niveau du pic j

MSE > Seuil — MSE < Seuil

Le pic j+1 influe sur le pic j

Le pic j+1 n'influe pas sur le pic j

Etude de l'influence du pic j sur le pic j+1

831

Reconstruction partielle des pics j+1 à n-1

832

Comparaison de la reconstruction partielle et de la reconstruction au niveau du pic j+1

MSE < Seuil — MSE > Seuil

Le pic j n'influe pas sur le pic j+1

Le pic j influe sur le pic j+1

ET

Les pics j et j+1 sont combinés

Les pics j et j+1ne sont pas combinés

Les pics j et j+1 sont combinés

FIG.8

FIG.9

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2018059164 A1

**Littérature non-brevet citée dans la description**

- **SALAMA MEGHRICHE.** Reconnaissance de Forme de Signaux Biologiques. *mémoire de thèse,* 2008
- **FELIX SCHOLKMANN ; JENS BOSS ; MARTIN WOLF.** An Efficient Algorithm for Automatic Peak Detection in Noisy Periodic and Quasi-Periodic Signals. *Algorithms,* 2012, vol. 5, 588-603
- **SAMIR OUELHA.** Représentation et reconnaissance des signaux acoustiques sous-marins. *mémoire de thèse,* 2014
- **M. A. BRANCH ; T. F. COLEMAN ; Y. LI.** A Subspace, Interior, and Conjugate Gradient Method for Large-Scale Bound-Constrained Minimization Problems. *SIAM Journal on Scientific Computing,* 1999, vol. 21 (1), 1-23
- The Levenberg-Marquardt Algorithm: Implementation and Theory. **J. J. MORE.** Lecture Notes in Mathematics. Springer Verlag, 1977, vol. 630, 105-116
- **R. H. BYRD ; R. B. SCHNABEL ; G. A. SHULTZ.** Approximate solution of the trust région problem by minimization over two-dimensional subspaces. *Math. Programming,* 1988, vol. 40, 247-263